# EUROPEAN PATENT APPLICATION

(11) **EP 4 167 266 A1**
(43) Date of publication of application: **19.04.2023**
(21) Application number: 21825836.6
(22) Date of filing: 14.06.2021
(51) Int. Cl.: H01J 37/20, H01J 37/22, H01J 37/244, H01J 37/28, G01N 1/28

(54) **OBSERVATION METHOD EMPLOYING SCANNING ELECTRON MICROSCOPE, AND SAMPLE HOLDER FOR SAME**

(30) Priority: 16.06.2020 JP 2020103469
(71) Applicant: Chubu University Educational Foundation, Kasugai-shi Aichi 487-8501 (JP)
(72) Inventor: SHINTANI, Seine, Kasugai-shi Aichi 487-8501 (JP); YAMAGUCHI, Seiji, Kasugai-shi Aichi 487-8501 (JP); TAKADAMA, Hiroaki, Kasugai-shi Aichi 487-8501 (JP)
(74) Representative: advotec.
(86) International application number: PCT/JP2021/022443
(87) International publication number: WO 2021/256412

(57) **Abstract**

Disclosed is a method with which it is possible to observe a biological sample in a living state, without significant restrictions due to the properties of the sample or due to a structural body accommodating the sample. To observe a target sample on a sample stage using a SEM including a radiation source for electron beam irradiation, the method includes:
a step of bringing an insulating and electron-permeable thin film into contact with the target sample in such a way as to follow a surface on the radiation source side of the target sample, and sealing the target sample in a gap between the film and the sample stage; and
a step of radiating an electron beam onto the target sample from the radiation source through the film.

## Description

### TECHNICAL FIELD

The present invention relates to an observation method employing a scanning electron microscope, and a sample holder for the same, and can be suitably used to observe a sample, such as a living organism, under a hydrated state or an environment with a fluid material.

### BACKGROUND ART

In a scanning electron microscope used under a high vacuum, a sample, such as a living organism, under a hydrated state or an environment with a fluid material requires pretreatment for preventing the sample from being deformed or damaged by evaporation of water, exposure to vacuum, or electron beam irradiation. The pretreatment is, for example, chemical fixation in which molecules constituting the sample are cross-linked, metal coating in which metal ions are applied to a surface of the sample that has been quickly cooled and frozen, and the like. In any case, movement of the sample has been stopped regardless of whether the sample is alive or dead, and movement of the sample cannot be observed.

Accordingly, some methods have been proposed to observe movement of a living biological sample. For example, in Patent Document 1, a composition for evaporation suppression is applied to a surface of a sample, and an electron beam or plasma is radiated to form a polymerized film on the surface, so that plastic deformation of or damage to the sample is prevented. In Non Patent Document 1, a hydrated sample is put in a container together with a solution, the opening of the container is closed up with an electron-permeable thin film, the thin film is reinforced with a grid that is more rigid than the thin film to maintain flatness of the thin film, an electron beam is radiated onto the sample through the thin film, and backscattered electrons are detected. The sample is in close contact with the thin film. To increase the permeability of the backscattered electrons, a film that is as thin as possible, such as a thickness of 145 nm, is considered optimal as the thin film.

In Patent Document 2, an electron beam is incident from above in a state where a sample is accommodated between a laminate including a first conductive thin film and an insulating thin film and a second conductive thin film, and secondary electrons that are transmitted through the sample and exit from the lower surface of the second conductive thin film are detected. In Patent Document 3, an electron beam having an intensity varying in a pulsed manner is incident from a conductive thin film side in a state where a sample together with a liquid is accommodated between a laminate including a conductive thin film and a first insulating thin film and a second insulating thin film, and an outer surface potential change of the second insulating thin film corresponding to the difference in dielectric constant between the sample and the liquid is measured.

### RELATED ART DOCUMENTS

### PATENT DOCUMENTS

Patent Document 1: Japanese Patent No. 6055766
Patent Document 2: Japanese Unexamined Patent Application Publication No. 2014-22323
Patent Document 3: Japanese Unexamined Patent Application Publication No. 2014-203733

### NON-PATENT DOCUMENTS

Non-Patent Document 1: Thiberge, S. et. al., "Scanning electron microscopy of cells and tissues under fully hydrated conditions.," Proc Natl Acad Sci USA., 101: 3346-3351, 2004.

### SUMMARY OF THE INVENTION

### PROBLEMS TO BE SOLVED BY THE INVENTION

However, in the method of Patent Document 1, the sample is inevitably exposed to a vacuum environment of about 1 Pa at which the electron beam or plasma can be radiated at a stage where the composition for evaporation suppression is applied to the surface of the sample but the polymerized film is not formed yet. Since water evaporates at about 1,000 Pa or less, a sample that cannot bear the application itself of the composition for suppression, evaporative cooling associated with evaporation of water contained in the composition for suppression, or the burden of osmotic pressure generated by remaining substances cannot be observed.

In the method of Non Patent Document 1, the sample is required to be stained with a compound containing a heavy metal element such as osmium in order to detect backscattered electrons, but such staining with a heavy metal element stops the vital activity or movement of the biological sample. In addition, observation of only a portion of the sample close to the thin film is possible, and the sense of distance in a direction orthogonal to the thin film cannot be given.

In the methods of Patent Documents 2 and 3, the sample is limited to a sample having such a thickness as to fit into the gap between the laminate and the second conductive thin film or the second insulating thin film facing the laminate. The gap distance preferably measures 200 um or less ([0043] in Patent Document 2) or 40 um or less ([0063] in Patent Document 3). Moreover, an image obtained by the method of Patent Document 2 is two-dimensional as in Non Patent Document 1, and an image obtained by the method of Patent Document 3 also does not show the actual structure but merely shows the two-dimensional distribution of the dielectric constant. Since a sample holder is disposed between a radiation source for electron beam irradiation and a detector in both of the methods of Patent Documents 2 and 3, the methods cannot be applied to many existing scanning electron microscopes in which a detector is located on the same side as a radiation source.

Accordingly, an object of the present invention is to provide a method with which it is possible to observe a biological sample in a living state, without significant restrictions due to the properties of the sample itself or due to a structural body accommodating the sample. Another object is to provide a method that can be applied to many existing scanning electron microscopes to observe the three-dimensional structure of a biological sample.

### MEANS OF SOLVING THE PROBLEM

To solve the problems, an observation method of the present invention is a method for observing a target sample on a sample stage using a scanning electron microscope including a radiation source for electron beam irradiation, the method including:
a sealing step of bringing an insulating and electron-permeable thin film into contact with the target sample in such a way that the thin film follows a surface on the radiation source side of the target sample, and sealing the target sample in a gap between the thin film and the sample stage; and
a radiating step of radiating an electron beam onto the target sample from the radiation source through the thin film.

The target sample may coexist with a fluid material or may be in a hydrated state. The fluid material refers to an ionic liquid, an aqueous solution, a gel, a sol, or the like.

When this method is carried out, the thin film is normally brought into contact with the target sample in such a way as to follow the surface on the radiation source side of the target sample with the target sample being on the sample stage. The thin film is normally caused to cover the target sample with a slight tension being applied to the thin film, so that the thin film is brought into close contact with the target sample due to the reaction force applied to the target sample by the sample stage. The target sample is sealed in the gap between the thin film and the sample stage in this state. The thin film follows the surface of the target sample. In the case where the target sample coexists with the fluid material, the surplus fluid material is removed, and the periphery of the sample is kept fluid-tight. In the case where the specific gravity of the target sample is sufficiently smaller than that of the fluid material and where the thin film is flexible to such an extent that the thin film is deformed due to the buoyancy of the sample, the sample may be floating on the fluid material.

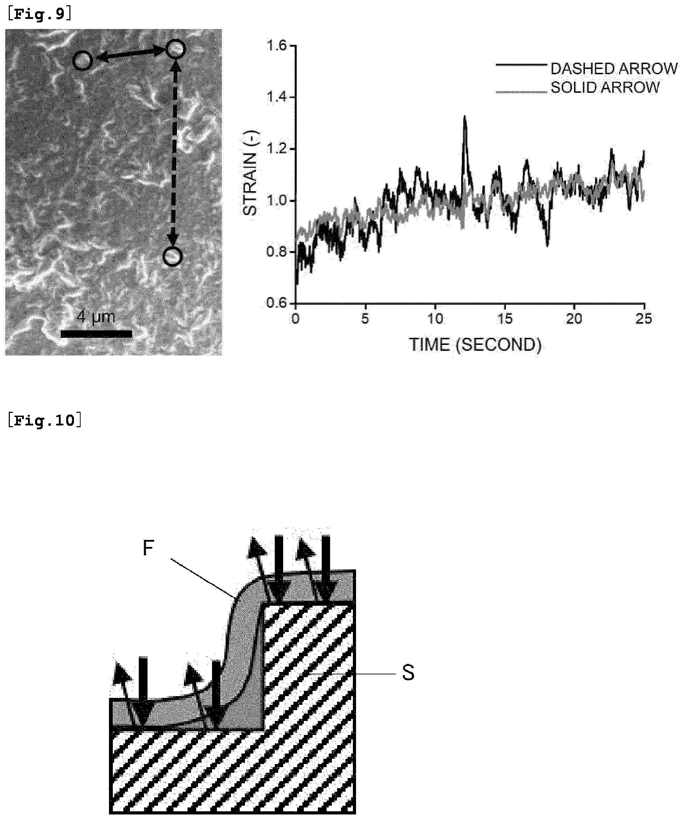

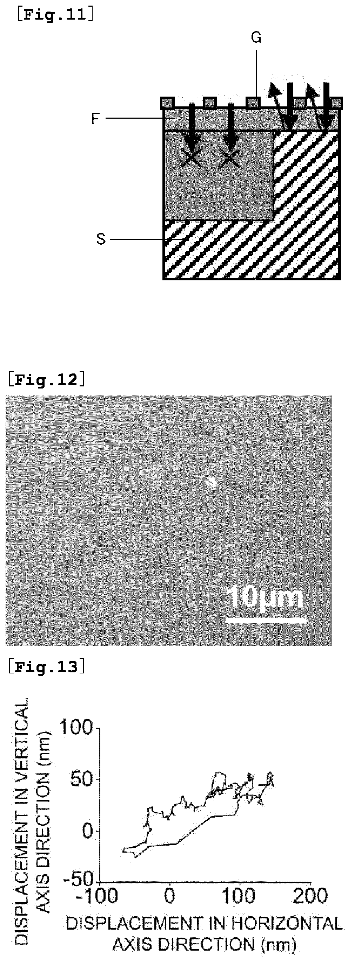

As shown in FIG. 10, the outer surface of a thin film F corresponds to the outer shape of a target sample S, and the thin film F follows the movement of the target sample S. Accordingly, radiating an electron beam (bold arrows in the drawing) toward the target sample S in this state enables observation of the three-dimensional structure and movement of the target sample S. The method remarkably differs in this point from the method of Non Patent Document 1 in which the thin film F is reinforced with a grid G as shown in FIG. 11 and in which the thin film F does not follow the target sample S, which enables observation of only the shape of the target sample S in a plan view. Not only in the case where the sample is in a hydrated state but also in the case where the coexisting fluid material is electrically conductive like an aqueous solution or the case where the thin film and a constituent in contact with the target sample are conductive materials, the target sample does not become charged, and a clear image is therefore obtained. The operation of covering the target sample with the thin film may be carried out in the air. Accordingly, water in the sample or the fluid material does not evaporate. Since an electron beam is radiated after the target sample is covered with the thin film, the target sample may not be resistant to a vacuum.

The observation is normally carried out by detecting secondary electrons generated from the target sample or the thin film at the time of the electron beam irradiation. This is because the target sample does not have to be stained, and the secondary electrons (thin arrows in FIG. 10) are generated from positions following the target sample S, which enables measurement of the direction and amount of the displacement of the target sample or the thin film with high precision. Accordingly, it is possible to actualize the observation method of the present invention using an existing scanning electron microscope in which a secondary electron detector is fixed on the radiation source side.

In the case where the target sample contains both of a light element and a heavy element or in the case where the outer surface of the thin film has been dusted with metal particles in only one layer, backscattered electron s can also be detected, whereby it is possible to measure the direction and amount of the displacement of the target sample or the thin film in the same way as in the detection of secondary electrons.

The thin film can preferably be elastically deformed according to the movement of the target sample. This is because the thin film is unlikely to be broken even in the case where the displacement of the target sample is large. It is also possible to measure, using the relative displacement between two or more points on the thin film, a stress caused between corresponding points on the target sample because the thin film is elastically deformed. The stress is determined by measuring the Young's modulus of the thin film according to the tensile force in advance and dividing the relative displacement between two points by the distance between the two points to determine the "strain" because the "stress" is the product of the "Young's modulus" and the "strain." This is because the source of the stress is a force generated by the sample.

A preferable constitution of the method of the present invention includes, in addition to the sealing step and the radiating step, a marker disseminating step of disseminating a marker to a surface of the thin film opposite to the target sample side before the radiating step. This constitution enables precise analysis of the movement of the marker on the film in addition to the measurement of the structure and movement of the sample under the film. Unlike measuring through the film the sample under the film, the marker on the film is measured without other materials therebetween, which makes it possible to make the most of the measurement precision of the scanning electron microscope. Moreover, it becomes possible to observe the movement of the sample with high precision while keeping an accelerating voltage to the sample low and suppressing the effect of electron beam irradiation on the sample. The marker may be formed before the sealing step, such as at the time of forming the thin film, or immediately before the radiating step without limitation as long as the marker is formed before the radiating step.

In another preferable constitution of the method of the present invention, the marker has a known shape, and in addition to the sealing, the marker disseminating and the radiating steps, an analysis step of analyzing astigmatism of the marker is included after the radiating step. Since movement in the height direction of the marker corresponds to that in the thickness direction of the film, by analyzing the astigmatism, it is possible to distinguish whether the movement in the height direction of the marker is directed toward the near side or the far side relative to the radiation source.

For example, in the case where a state in which the sample and the thin film do not move relative to each other is maintained, it is possible to measure the shape of the sample with high resolution by performing alignment with a single marker being the center and integrating a plurality of images. In the case where the sample and the thin film move relative to each other, it is possible to precisely analyze the structural change and movement of the sample with the marker serving as a coordinate point. The shape and material of the marker are not limited, but a diameter of 0.5 nm or more and 1 mm or less is preferred in the case of a spherical shape. Note that a marker that stays on the thin film because of frictional force or adhesive force of an adhesive is desirable and that a marker that rolls on the thin film is not preferable.

A sample holder for a scanning electron microscope appropriate for the observation method of the present invention includes:
a sample stage capable of supporting a target sample such that the target sample faces a radiation source for electron beam irradiation of the scanning electron microscope;
an insulating and electron-permeable thin film; and
means for sealing the target sample in a gap between the thin film and the sample stage such that the thin film is brought into contact with the target sample in such a way as to follow a surface on the radiation source side of the target sample.

It is desirable that no member other than the sealing means be present near the surface on the radiation source side of the thin film so as not to hinder the displacement of the sample and the thin film during observation of the sample.

The sample holder of the present invention preferably further includes adjusting means for adjusting a tension applied to the thin film. Adjusting the tension applied to the thin film enables various properties of the target sample to be observed. Increasing the tension improves accuracy of the follow of the thin film to the target sample and enables a more minute structure of the target sample to be observed. On the other hand, reducing the tension reduces the binding force applied to the target sample and enables large movement of the target sample to be observed.

One or two or more spacers disposed between the target sample and the sample stage are preferably employed as the adjusting means. This is because it becomes easy for the thin film to follow the target sample even in the case where the target sample is thin. A plurality of spacers with different thicknesses or elastic moduli are preferably prepared so that a spacer suited to the properties of the target sample can be applied. Examples thereof include cotton, melamine sponge, and biomaterial spacers such as heart, liver, and kidney. A plurality of spacers may be used simultaneously, and at least one of the spacers is preferably elastic in this case. It is possible to quantitatively adjust the surface pressure and tension applied to the thin film using the abilities and height of the spacer, thereby optimizing the observation conditions.

The thin film is required to bear the difference in pressure (100,000 Pa) between a vacuum and atmospheric pressure because a space above the thin film is vacuum while the environment of the target sample during the observation is almost at atmospheric pressure, required to be proof against breakage caused by the action force or the like applied by the sample, and preferably made of an organic polymer, particularly preferably a polyimide. This is because such a film has not only insulating and electron-permeable properties optimal for the thin film of the present invention but also optical transmittance in addition to the above abilities, and a film having an appropriate size can be easily synthesized from a commercially available polyimide precursor. In the case where the thin film is made of a polyimide, the thin film preferably has a thickness of 100 nm or more and 5 µm or less. The preferable thickness is set to 100 nm or more because a thickness less than 100 nm results in insufficient strength and because the film sufficiently reflects the shape and movement of the target sample even in the case where secondary electrons emitted from the thin film with a thickness of 100 nm or more are detected. The preferable thickness is set to 5 µm or less because a thickness larger than 5 µm makes it difficult to follow displacement of the target sample.

The sample stage is preferably made of a conductive material. This is because this constitution can prevent distortion of an image associated with charging of the sample just by imparting electrical conductivity to the fluid material or employing conductive materials as the materials of the thin film or the target sample and a constituent in contact with the sample stage.

One preferable constitution of the sealing means includes:
a sealing member present between the thin film and the sample stage and capable of being elastically deformed in a direction orthogonal to a surface of the sample stage on the thin film side;
a rigid pressing member sandwiching the thin film with the sealing member; and
a fixing member fixing the pressing member to the sample stage.

In this constitution, it is possible to cause the thin film to follow samples with various thicknesses or hardness by using sealing members with different heights or elasticity. The tension applied to the thin film can also be adjusted using the thickness or elasticity of the sealing member, the thickness of the pressing member, or the screwing amount of a bolt when the bolt is used as the fixing member. Accordingly, each of these members functions as the adjusting means as well as an element of the sealing means.

Another constitution preferable as the sealing means is an adhesive that bonds the periphery of the thin film to the sample stage. A smaller number of parts and less man-hours than the constitution described above are sufficient.

The size of the target sample is not limited, but a sample having a size of 1 nm or less is difficult to measure at sufficient resolution because observation is required to be performed through the thin film. In addition, a sample having a size of 50 cm or more cannot be sealed on a sample holder that can be installed in the sample chamber of an existing electron microscope. The size of the sample is desirably 1 nm or more and 50 cm or less.

### EFFECTS OF THE INVENTION

In the present invention, the target sample is not exposed to a vacuum or other chemical substances because the target sample is sealed by the thin film and the sample stage as described above before an electron beam is radiated onto the target sample. In addition, there is no strict limitation on the gap distance between the thin film and the sample stage because the thin film is brought into contact with the target sample in such a way as to follow the target sample. Accordingly, it is possible to observe a biological sample in a living state, without significant restrictions due to the properties of the sample itself or due to a structural body accommodating the sample. Furthermore, with the present invention, secondary electrons emitted from the target sample and the thin film can be detected, so that the present invention can be applied to many existing scanning electron microscopes to observe the three-dimensional structure of a biological sample.

### BRIEF DESCRIPTION OF THE DRAWINGS

FIG. 1 is a cross-sectional view in the vertical direction showing a sample chamber of a scanning electron microscope according to Embodiment 1.
FIG. 2 is a cross-sectional view in the vertical direction showing a sample chamber of a scanning electron microscope according to Embodiment 2.
FIG. 3 is an SEM micrograph of fluorescent microspheres with which a thin film has been brought into contact in accordance with Embodiment 1.
FIG. 4 is an SEM micrograph of a blood tissue with which the thin film has been brought into contact in accordance with Embodiment 1.
FIG. 5 is an SEM micrograph of a section of cardiac muscle fibers with which a thin film has been brought into contact in accordance with Embodiment 1.
FIG. 6 is an SEM micrograph of a section of collagen fibers with which a thin film has been brought into contact in accordance with Embodiment 1.
FIG. 7 is an SEM micrograph of a semiconductor chip with which a thin film has been brought into contact.
FIG. 8 is an SEM micrograph of a semiconductor chip with which another thin film has been brought into contact.
FIG. 9 includes a SEM micrograph of a section of cardiac muscle fibers with which the thin film has been brought into contact, and a graph showing changes of the strain over time.
FIG. 10 schematically illustrates the action of the present invention.
FIG. 11 schematically illustrates the action of the conventional art disclosed in Non-Patent Document 1.
FIG. 12 is a SEM micrograph of a thin film of a sample holder on which heart has been sealed and a marker disseminated over the thin film.
FIG. 13 is a graph showing the locus of the marker.
FIG. 14 includes SEM micrographs capturing changes over time of a calcium phosphate crystal separated inside a fluid material in a state where a thin film has been brought into contact in accordance with Embodiment 1.

### MODE FOR CARRYING OUT THE INVENTION

### - Embodiment 1 -

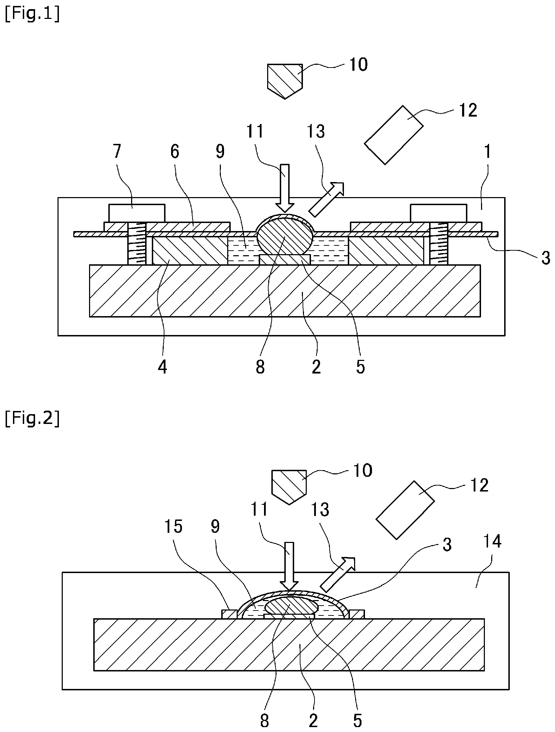

As shown in FIG. 1, a sample holder 1 for a scanning electron microscope according to the first embodiment includes a sample stage 2 made of a conductive material, specifically aluminum, a thin film 3 made of an insulating and electron-permeable organic polymer, a waterproof sealing member 4 that is made of an elasticity material and has a ring shape or a circular cylindrical shape, a disc-shaped spacer 5 made of an elastic material, an annular pressing member 6 made of a rigid material, and a plurality of bolts 7 corresponding to fixing members. Any of these parts can be combined together and separated from one another regardless of whether the timing is before or after use.

The sealing member 4 has an outer circumference located sufficiently inside the edges of the sample stage 2. The thin film 3 has a size enough to close one opening of the sealing member 4 and to extend outward beyond the outer circumference of the sealing member 4. The spacer 5 has an outer diameter enough to prevent contact with the inner circumference of the sealing member 4 and a height sufficiently smaller than the height of the sealing member 4. The pressing member 6 has an inner circumference having the same center and the same outer diameter as the inner circumference of the sealing member 4, and the outer edges protrude from the sealing member 4. Tapped holes (not shown) that are engaged with the bolts 7 are provided at positions on the upper surface of the sample stage 2, the positions protruding from the sealing member 4, and through holes are provided at the corresponding positions of the pressing member 6.

When the sample holder 1 is used, the sealing member 4 is put almost at the center of the sample stage 2, and the spacer 5 having appropriate thickness and elasticity according to the properties of a sample 8 is put inside the sealing member 4. The sample 8 is put on the spacer 5, and the periphery of the sample 8 is filled with a fluid material 9 such as an aqueous solution. The thin film 1 is put on the sealing member 8 to close the opening of the sealing member 8, the pressing member 6 is then put, and the bolts 7 are inserted into the through holes of the pressing member 6 and engaged with the tapped holes of the sample stage 2. By engaging the bolts 7, the sealing member 4 and the spacer 5 are compressed, and the thin film 3 is lightly pressed against the sample 8 and follows the shape of the upper surface of the sample 8. The surplus fluid material 9 oozes out of the gap between the sealing member 4 and the thin film 3 or the sample stage 2. Since the sealing member 4 is flexibly in contact with the thin film 3 pressed by the pressing member 6, the periphery of the sample 8 is kept fluid-tight.

The above operations may be carried out outside the sample chamber of the scanning electron microscope, such as in the air at normal temperature. The sample holder 1 on which the sample 8 and the fluid material 9 have been sealed is put in the sample chamber such that the sample 8 faces a radiation source 10 for electron beam irradiation across a lens. The sample stage 2 is electrically grounded. A secondary electron detector 12 is installed above the sample holder 1 at such a position as not to obstruct the path of an electron beam 11 radiated from the radiation source 10. There is no member other than the detector 12 up to the lens above a portion of the thin film 3 surrounded by the inner circumference of the sealing member 4.

When the electron beam 11 is radiated from the radiation source 10 in this state, incident electrons that are not applied to the sample 8 and backscattered electrons flow through the fluid material 9 and the sample stage 2 to the ground. Accordingly, either of the sample 8 and the thin film 3 will not become charged. On the other hand, since the thin film 3 has insulating and electron-permeable properties, secondary electrons 13 emitted from the surface of the sample 8 and the thin film 3 are detected by the detector 12. The thin film 3 has projections and depressions following the surface of the sample 8, and follows the movement of the sample 8, so that the intensity of the secondary electron 13 to be detected varies depending on the angle of the surface of the sample 8 or the thin film 3 with the incident electron beam. Accordingly, it is possible to measure the microstructure and the direction and amount of the displacement of the sample 8.

### - Embodiment 2 -

A sample holder 14 for a scanning electron microscope according to the second embodiment differs from that in the first embodiment in that none of the sealing member 4, the pressing member 6, and the bolts 7 are included. An adhesive 15 is included instead as shown in FIG. 2.

When the sample holder 14 is used, the spacer 5 is put almost at the center of the sample stage 2, and the adhesive 15 is applied to the periphery of the thin film 3. Before the adhesive 15 becomes dry, the sample 8 moistened by the fluid material 9 is put on the spacer 5, the sample 8 is covered with the thin film 3 while applying a tension to the thin film 3 with the surface to which the adhesive 15 has been applied facing downward, and the periphery of the thin film 3 is pressed against the sample stage 2. After fixing of the thin film 3 to the sample stage 2 has been completed, the sample holder 14 is put in the sample chamber. The procedure after that may be the same as in the first embodiment.

### EXAMPLE 1

A sample was sealed on the sample holder of the first embodiment and put in a sample chamber of a field emission scanning electron microscope in which the pressure of the sample chamber was about 1 Pa, and observation was carried out. Details are described below.

Biphenyltetracarboxylic acid dianhydride (U-Varnish-S 1001) manufactured by Ube Industries, Ltd. was provided as the polyimide precursor. The polyimide precursor was thinly applied to a substrate made of optical glass BK7 and having a thickness of 0.17 mm by spin coating, and the substrate was heated in an electric furnace at a temperature of 450°C for 20 minutes, followed by peeling the resultant coat from the substrate in water to provide a polyimide thin film having a size of 32 × 24 mm and a thickness of 300 nm, which was regarded as the thin film 3.

A product obtained by adding 10% of newborn calf serum, 100 unit/ml of penicillin, and 100 µg/ml of streptomycin to a 1:1 mixed culture medium of Dulbecco's Modified Eagle's Medium and Ham's F12 Nutrient Mixture was used as the fluid material 9. A plurality of fluorescent beads that were made of polystyrene and had a density of 1.05 g/cm³ and an average particle diameter of 1 µm manufactured by Polysciences Inc. were used as the sample 8.

An O-ring made of silicone rubber (JIS material code: 4C) conforming to JIS Standard P11 and having an inner diameter of 10.8 mm and a thickness of 2.4 mm was used as the sealing member 4 such that its center line coincided with the center of the radiation field. The spacer 5 was made of melamine sponge, and the pressing member 6 was made of a stainless steel plate. Four bolts 7 were disposed evenly in the circumferential direction.

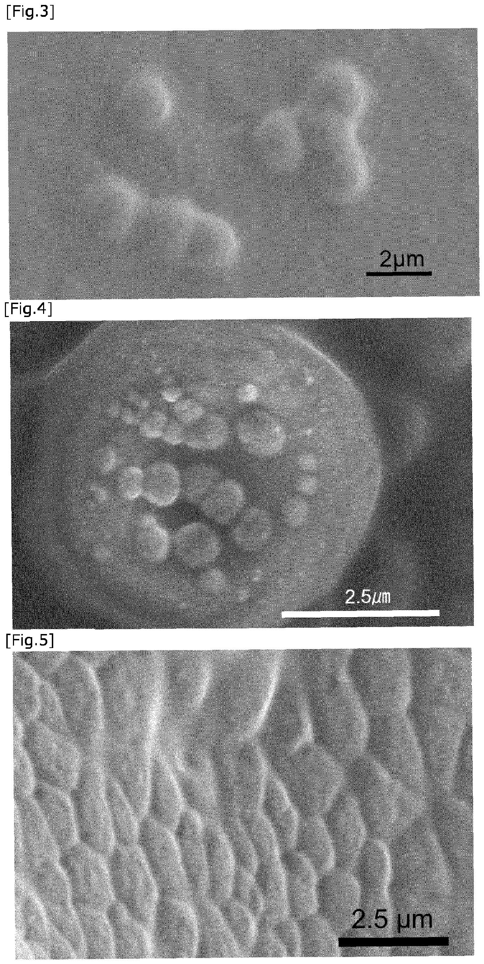

FIG. 3 shows the result of observation of the sample 8 by detecting the secondary electrons 13 with the detector 12. An independent fluorescent bead is shown in the upper left portion of the image, an aggregate of four fluorescent beads is shown in the upper right portion, and an aggregate of three fluorescent beads is shown in the lower left portion.

### EXAMPLE 2

A blood tissue of a mouse was used as the sample 8 instead of the fluorescent beads. FIG. 4 shows the result of observation of the sample 8 carried out in the same way as in Example 1 except for the above point. A circular object occupying an area of about 2/3 of the screen is shown at the center of the image and is identified as a red blood cell. Other vesicles and granules derived from the blood tissue are observed on and around the red blood cell.

### EXAMPLE 3

The heart extracted from a mouse was used as the sample 8 instead of the fluorescent beads and sealed on the sample holder 1. A region of a section of the heart tissue in which the sections of the cardiac muscle fibers were oriented in the direction toward the radiation source 10 was searched out and observed. FIG. 5 shows the result of observation of the sample 8 carried out in the same way as in Example 1 except for the above point. It is possible to observe that each bundle of cardiac myofibrils having a diameter of about 1 µm densely gathered to have a hexagonal or quadrangular shape.

### EXAMPLE 4

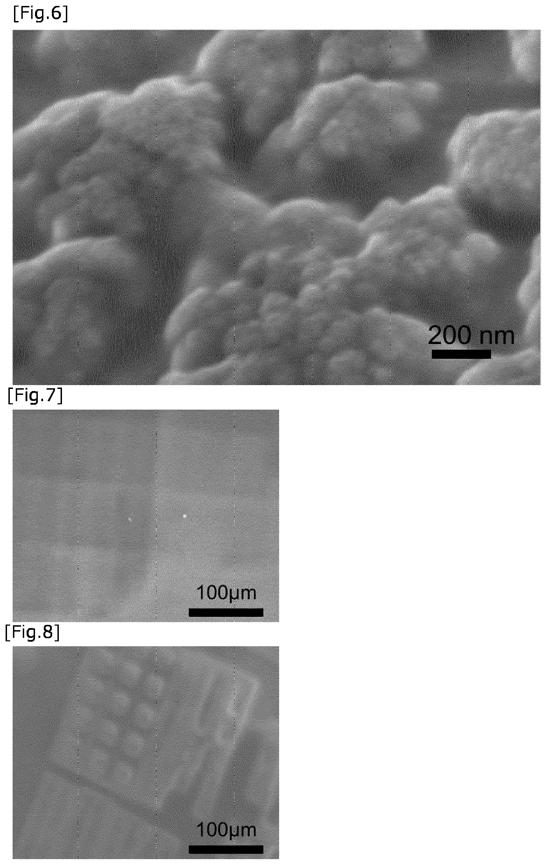

The heart extracted from a mouse was used as the sample 8 instead of the fluorescent beads and sealed on the sample holder 1. A region of a section of the heart tissue in which the sections of collagen fibers were oriented in the direction toward the radiation source 10 was searched out and observed. FIG. 6 shows the result of observation of the sample 8 carried out in the same way as in Example 1 except for the above point. It is possible to observe that collagen microfibrils having diameters of about 20 to 60 nm that are smaller than 200 nm, which is the resolution of an optical microscope and the length of the scale bar, form bundles having diameters of 400 to 800 nm, and the bundles gather to form collagen fibers.

### EXAMPLE 5

A thermoplastic polyimide varnish (Q-AD-X0516) manufactured by PI R&D Co., Ltd. was provided as the polyimide precursor. The polyimide precursor was thinly applied to a substrate made of optical glass BK7 and having a thickness of 0.17 mm by spin coating at 6,000 rpm, and the substrate was heated on a hot plate at a temperature of 200°C for 3 minutes, followed by peeling the resultant coat from the substrate in water to provide a polyimide thin film having a size of 32 × 24 mm and a thickness of 4 µm. A polyimide thin film having a thickness of 1.5 µm was provided in the same way as described above except that a spin speed of 8,000 rpm was employed in the spin coating instead of a spin speed of 6,000 rpm.

A semiconductor chip was covered with the polyimide thin film having a thickness of 4 µm with a slight tension being applied to the thin film and observed with a scanning electron microscope under a condition of an accelerating voltage of 15 kV, and the resulting image is shown in FIG. 7. The same semiconductor chip was covered with the polyimide thin film having a thickness of 1.5 µm in the same way and observed under the same condition, and the resulting image is shown in FIG. 8. By comparison between the two images, it is shown that the shape of the surface of the semiconductor chip is more accurately reflected in the case of the thin film having a smaller thickness.

### EXAMPLE 6

In the same way as in Example 4, the heart extracted from a mouse was sealed on the sample holder 1, followed by taking a video of the state where the thin film 3 closely adhered to the heart tissue and where the heart and the thin film expanded and contracted. A still image at that moment is shown in the left side of FIG. 9. Changes of the strain over time were measured by dividing each of a relative displacement (distance variation indicated by the solid double-pointed arrow) in the horizontal direction and a relative displacement (distance variation indicated by the dashed double-pointed arrow) in the vertical direction among relative displacements between three appropriate regions on the thin film encircled by circles in the image shown in the drawing by the time-average distance. The measurement result is shown on the right side of the image in FIG. 9. The measurement result shows that the heart tissue was vibrating in all directions such as horizontal, oblique, and vertical directions because changes in the horizontal direction and the vertical direction vibrated while coinciding with each other and being independent from each other. That is, such physical properties (restoring force) and behavior of the heart tissue that the contractile system of the cardiac muscle is oriented in a twisted way and can contract and relax in a plurality of directions is reflected.

### EXAMPLE 7

The heart extracted from a mouse was sealed on the sample holder 1 in the same way as in Example 4. At the time of forming the thin film 3, a step of applying on the substrate a polyimide precursor caused to contain microbubbles by stirring instead of applying the normal polyimide precursor and heating the product on a hot plate at 200°C for 5 minutes immediately after the application was added before the heating step with an electric furnace, so that spherical markers derived from the microbubbles were obtained on the surface of the thin film 3 as shown in FIG. 12. Among the spherical markers derived from the microbubbles, movement of a marker (at the upper right position near the center of FIG. 12) having a diameter of 1.4 µm was analyzed, and the result is shown in FIG. 13. The drawing shows that the locus of the movement of the marker was able to be measured with high precision. Since relative movement between the marker and the thin film 3 or between the thin film 3 and the heart does not occur, the movement of the marker corresponds to that of the heart directly under the marker.

The marker may be produced by mixing minute particles with the raw material of the thin film to disperse the particles at the time of forming the film or by printing the markers on the film after formation of the film without mixing minute particles with the raw material of the thin film.

### EXAMPLE 8

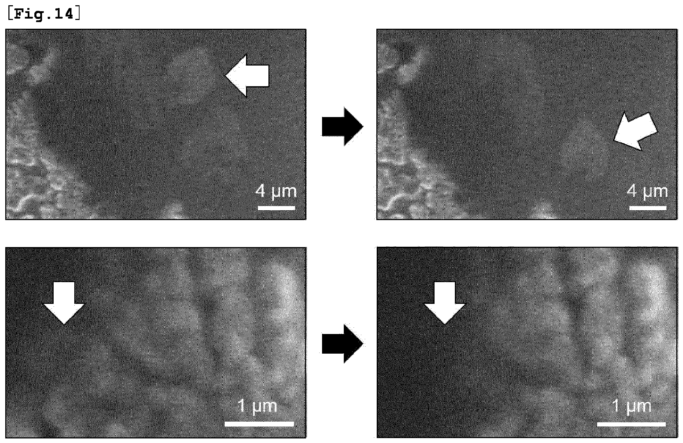

A product obtained by adding 10% of newborn calf serum, 100 unit/ml of penicillin, and 100 µg/ml of streptomycin to a 1:1 mixed culture medium of Dulbecco's Modified Eagle's Medium and Ham's F12 Nutrient Mixture was used as the fluid material 9 and sealed on the sample holder 1. A calcium phosphate crystal separated from the fluid material 9 near the thin film 3 was used as the sample 8, and the behavior of the crystal was imaged. The result is shown in FIG. 14. In the drawing, the upper right and lower right images show the same portions as the upper left and lower left images, respectively, after the lapse of time.

As shown in the drawing, it is possible to observe a crystal floating and moving in the fluid material 9 directly under the thin film 3. That is, it is possible to confirm that the crystal indicated by the white arrows in the drawing moved from the position shown in the upper left image to the position shown in the upper right image. As the separation of a crystal progresses, the thin film 3 is deformed to follow the shape of the crystal, and the shape of the crystal can be three-dimensionally observed. The shape of the crystal can be observed in the lower left portions of the upper left image and the upper right image and in the right portions of the lower left image and the lower right image. In addition, since the crystal in the portion indicated by the white arrow in the lower left image is not observed in the lower right image, it is possible to confirm that the crystal that had been separated near the thin film 3 and deformed the thin film 3 moved away from the thin film 3 and sank into the fluid material 9.

### Reference Signs List

- 1, 14: sample holder
- 2: sample stage
- 3: thin film
- 4: sealing member
- 5: spacer
- 6: pressing member
- 7: bolt
- 8: sample
- 9: fluid material
- 10: radiation source
- 11: electron beam (incident electron)
- 12: detector
- 13: secondary electron
- 15: adhesive

## Claims

1. A method for observing a target sample on a sample stage using a scanning electron microscope comprising a radiation source for electron beam irradiation, the method comprising:
a sealing step of bringing an insulating and electron-permeable thin film into contact with the target sample in such a way that the thin film follows a surface on the radiation source side of the target sample, and sealing the target sample in a gap between the thin film and the sample stage; and
a radiating step of radiating an electron beam onto the target sample from the radiation source through the thin film.

2. The method according to claim 1, wherein the target sample coexists with a fluid material or is in a hydrated state.

3. The method according to claim 1 or 2, wherein the observation is carried out by detecting a secondary electron emitted from the target sample or the thin film at a time of the electron beam irradiation.

4. The method according to any one of claims 1 to 3, wherein the thin film is capable of being elastically deformed according to movement of the target sample.

5. The method according to claim 4, wherein, using a relative displacement between two or more points on the thin film, a stress caused between corresponding points on the target sample is measured.

6. The method according to any one of claims 1 to 5, further comprising a marker disseminating step of disseminating a marker to a surface of the thin film opposite to the target sample side before the radiating step.

7. The method according to claim 6, further comprising an analysis step of analyzing astigmatism of the marker after the radiating step, wherein the marker has a known shape.

8. A sample holder for a scanning electron microscope, comprising:
a sample stage capable of supporting a target sample such that the target sample faces a radiation source for electron beam irradiation of the scanning electron microscope;
an insulating and electron-permeable thin film; and
means for sealing the target sample in a gap between the thin film and the sample stage such that the thin film is brought into contact with the target sample in such a way that the thin film follows a surface on the radiation source side of the target sample.

9. The sample holder according to claim 8, further comprising adjusting means for adjusting a tension applied to the thin film.

10. The sample holder according to claim 9, wherein the adjusting means comprises one or two or more spacers disposed between the target sample and the sample stage.

11. The sample holder according to claim 10,
wherein the spacers comprise a plurality of spacers, and
wherein at least one of the spacers comprises an elastic material.

12. The sample holder according to any one of claims 8 to 11, wherein the thin film comprises a polyimide.

13. The sample holder according to claim 12, wherein the thin film has a thickness of 100 nm or more and 5 µm or less.

14. The sample holder according to any one of claims 8 to 13, wherein the sample stage comprises a conductive material.

15. The sample holder according to any one of claims 8 to 14, wherein the sealing means comprises:
a sealing member present between the thin film and the sample stage and capable of being elastically deformed in a direction orthogonal to a surface of the sample stage on a thin film side;
a rigid pressing member sandwiching the thin film with the sealing member; and
a fixing member fixing the pressing member to the sample stage.

16. The sample holder according to claim 15,
wherein the pressing member extends outward beyond the sealing member, and
wherein the fixing member comprises a bolt configured to pass through a portion of the pressing member extending outward and be screwed into the sample stage without interfering with the sealing member.

17. The sample holder according to any one of claims 8 to 14, wherein the sealing means comprises an adhesive bonding a periphery of the thin film to the sample stage.
